# EUROPÄISCHE PATENTSCHRIFT

(11) **EP 3 204 261 B1**
(45) Veröffentlichungstag und Bekanntmachung des Hinweises auf die Patenterteilung: **20.11.2019**
(21) Anmeldenummer: 15770803.3
(22) Anmeldetag: 25.09.2015
(51) Int. Cl.: B60Q 11/00, F21S 41/16, F21S 45/70

(54) **ÜBERWACHEN EINER EINE KONVERSIONSVORRICHTUNG UND EIN LASERBASIERTES LEUCHTMITTEL AUFWEISENDEN BELEUCHTUNGSEINRICHTUNG**
MONITORING AN ILLUMINATION DEVICE COMPRISING A CONVERSION DEVICE AND LASER-BASED ILLUMINATING MEANS
SURVEILLANCE D'UN DISPOSITIF D'ÉCLAIRAGE POURVU D'UN DISPOSITIF DE CONVERSION ET D'UN MOYEN LUMINEUX À LASER

(30) Priorität: 07.10.2014 DE 102014014852
(43) Veröffentlichungstag der Anmeldung: 16.08.2017
(73) Patentinhaber: Audi AG, 85045 Ingolstadt (DE)
(72) Erfinder: GUT, Carsten, 85051 Ingolstadt (DE); KOCH, Florian, 64732 Bad König (DE)
(74) Vertreter: Thielmann, Frank
(86) Internationale Anmeldenummer: PCT/EP2015/001905
(87) Internationale Veröffentlichungsnummer: WO 2016/055142

(56) Entgegenhaltungen:
- WO-A1-2013/096984
- DE-A1-102012 220 481
- DE-B3-102012 220 476
- DE-U1-202015 001 682
- US-A1- 2011 063 115

## Beschreibung

Die vorliegende Erfindung betrifft eine Konversionsvorrichtung für einen Kraftfahrzeugscheinwerfer mit einem Leuchtstoff zum Konvertieren von empfangenem Licht in Konversionslicht und einem Sensorelement zum Überwachen des Leuchtstoffs. Weiterhin betriff die Erfindung einen Kraftfahrzeugscheinwerfer zum Bereitstellen von Licht für Beleuchtungszwecke, mit einem Leuchtmittel zum Erzeugen von Licht und einer Konversionsvorrichtung. Die Erfindung betrifft ferner ein Kraftfahrzeug. Schließlich betrifft die Erfindung auch ein Verfahren zum Überwachen einer Konversionsvorrichtung mit folgenden Schritten: Empfangen von Licht eines Leuchtmittels mit mindestens einer vorgebbaren Wellenlänge durch die Konversionsvorrichtung, Wandeln des empfangenen Lichts in Konversionslicht mittels mindestens eines Leuchtstoffes der Konversionsvorrichtung, und Erfassen einer bestimmungsgemäßen Funktion der Konversionsvorrichtung mittels eines Sensorelements.

Gattungsgemäße Konversionsvorrichtungen, Kraftfahrzeugscheinwerfer sowie Kraftfahrzeuge hiermit und auch Verfahren sind dem Grunde nach bekannt. Sie dienen dazu, laserbasierte Beleuchtungseinrichtungen dahingehend zu überwachen, dass die bestimmungsgemäße Funktion des Leuchtstoffes überwacht wird, damit sicher gestellt werden kann, dass nicht in unerwünschter Weise Laserlicht des laserbasierten Leuchtmittels freigesetzt werden kann. Besonders wichtig ist dies bei Beleuchtungsvorrichtungen, die im öffentlichen Bereich sowie auch als mobile Beleuchtungseinrichtungen eingesetzt werden. Hier sind besonders hohe Sicherheitsanforderungen einzuhalten. Aus unterschiedlichsten Gründen kann die Konversionsvorrichtung, insbesondere der Leuchtstoff, einer Alterung und/oder einer Beschädigung unterliegen, sodass unter ungünstigen Umständen Laserlicht in nicht unerheblicher Intensität frei gesetzt werden kann.

Um unerwünschte oder auch gefährliche Zustände durch freigesetztes Laserlicht vermeiden beziehungsweise verhindern zu können, weisen derartige Beleuchtungseinrichtungen Überwachungseinrichtungen auf, die mittels Sensoren die bestimmungsgemäße Funktion des Leuchtstoffs überwachen, indem die Sensoren zum Detektieren von Laserlicht oder auch Konversionslicht ausgebildet sind. Eine solche Überwachungseinrichtung offenbart beispielsweise die WO 2013/096 984 A1. Diese befasst sich mit dem Einsatz von Laserlichtquellen in Kraftfahrzeugen. Zur Erfassung der zuverlässigen bestimmungsgemäßen Funktion wird eine Vielzahl von spezifischen Sensoren eingesetzt, die zur Detektion unterschiedlichster Fehlerszenarien adaptiert sind. Obwohl sich die Lehre der WO 2013/096 984 A1 dem Grunde nach bewährt hat, besteht Verbesserungsbedarf. Insbesondere erweist sich die Vielzahl unterschiedlicher Sensoren als sehr kosten- und aufwandsintensiv.

Die Erfindung hat es sich zur Aufgabe gemacht, eine einfache und zuverlässige Überwachung der Konversionseinrichtung, insbesondere des Leuchtstoffes, zu ermöglichen.

Als Lösung wird mit der Erfindung eine Konversionsvorrichtung gemäß dem unabhängigen Anspruch 1 vorgeschlagen. Weiterhin wird mit der Erfindung ein Kraftfahrzeugscheinwerfer gemäß dem Anspruch 6 vorgeschlagen. Darüber hinaus wird mit der Erfindung auch ein Kraftfahrzeug gemäß dem Anspruch 7 vorgeschlagen. Schließlich wird mit der Erfindung ein Verfahren gemäß dem unabhängigen Anspruch 8 vorgeschlagen. Weitere vorteilhafte Ausgestaltungen ergeben sich anhand von Merkmalen der abhängigen Ansprüche.

Konversionsvorrichtungsseitig wird mit der Erfindung insbesondere vorgeschlagen, dass das Sensorelement eine Ultraschalleinheit mit einem Ultraschallgeber und -empfänger umfasst. Die Ultraschalleinheit ist vorzugsweise akustisch mit dem Leuchtstoff gekoppelt.

Kraftfahrzeugscheinwerferseitig wird insbesondere eine Beleuchtungseinrichtung mit einer erfindungsgemäßen Überwachungseinrichtung vorgeschlagen. Kraftfahrzeugseitig schlägt die Erfindung insbesondere vor, dass das Fahrzeug einen Kraftfahrzeugscheinwerfer gemäß der Erfindung hat.

Schließlich wird verfahrensseitig insbesondere vorgeschlagen, dass das Erfassen mittels Ultraschall erfolgt, zu welchem Zweck der Leuchtstoff mittels eines Sensorelements mit Ultraschall beaufschlagt wird.

Die Erfindung basiert auf der Erkenntnis, dass bereits kleinste Abweichungen hinsichtlich der bestimmungsgemäßen Funktion der Konversionseinrichtung beziehungsweise des Leuchtstoffes mittels Ultraschall zuverlässig, sicher und einfach erfasst werden können. Auf diese Weise kann erreicht werden, dass eine zuverlässige Überwachung der Konversionseinrichtung beziehungsweise des Leuchtstoffes vorzugsweise mit lediglich einem einzigen Sensorelement erreicht werden kann. Dabei nutzt die Erfindung die Erkenntnis, dass bestimmungswidrige Abweichungen der Funktion der Konversionseinrichtung beziehungsweise des Leuchtstoffes die Folge materieller Veränderungen sind, die mittels Ultraschall einfach und zuverlässig detektiert werden können.

Das Leuchtmittel ist ein laserbasiertes Leuchtmittel, welches Laserlicht, mindestens einer einzigen Wellenlänge, erzeugt. Darüber hinaus kann das Leuchtmittel natürlich auch eine oder mehrere Leuchtdioden, Gasentladungslampen und/oder dergleichen aufweisen. Das laserbasierte Leuchtmittel kann beispielsweise ein Festkörperlaser wie eine Laserdiode oder dergleichen, ein Gaslaser oder dergleichen sein. Vorzugsweise wird das Leuchtmittel mit elektrischer Energie beaufschlagt, um das Licht zu erzeugen. Natürlich kann auch vorgesehen sein, dass das laserbasierte Leuchtmittel Laserlicht mit mehreren, insbesondere einer Vielzahl von vorgebbaren Wellenlängen erzeugt. Diesbezüglich kann das Leuchtmittel auch einstellbar ausgebildet sein, sodass Licht mit einer einstellbaren Wellenlänge erzeugt werden kann. Der Leuchtstoff kann beispielsweise Phosphorsalze oder dergleichen aufweisen. Das Leuchtmittel erzeugt Licht mit mindestens einer Wellenlänge. Es kann auch vorgesehen sein, dass das Leuchtmittel Licht mit mehreren Wellenlängen erzeugt. Schließlich kann auch vorgesehen sein, dass mehrere Leuchtmittel das Licht erzeugen, das von der Konversionsvorrichtung gewandelt wird.

Das Leuchtmittel ist vorzugsweise ebenso wie die Konversionsvorrichtung Bestandteil des Kraftfahrzeugscheinwerfers. Natürlich ist die Anwendung nicht auf Kraftfahrzeugscheinwerfer beschränkt, sondern kann auf beliebige Beleuchtungseinrichtungen angewendet werden. Die Beleuchtungseinrichtung ist eine Einrichtung, mittels der in vorgebbarer Weise Licht für Beleuchtungszwecke bereitgestellt werden kann. Insbesondere betrifft dies die Beleuchtung von Räumen, das Ausleuchten von Fahrwegen (Kraftfahrzeugscheinwerfer), Sicherheitsbeleuchtungen, das Beleuchten von öffentlichen Räumen und/oder dergleichen. Für diese Beleuchtungszwecke ist das Licht des Leuchtmittels zunächst wenig geeignet, insbesondere wenn es sich um Laserlicht handelt, weshalb es der Konversionsvorrichtung zugeführt wird, insbesondere dem Leuchtstoff der Konversionsvorrichtung. Der Leuchtstoff empfängt das Licht des Leuchtmittels. Mittels des Leuchtstoffes kann das empfangene Licht in vorgebbarer Weise in Konversionslicht gewandelt werden, wobei der Leuchtstoff derart ausgebildet ist, dass vorzugsweise weißes Licht erzeugt werden kann. Zu diesem Zweck kann vorgesehen sein, dass der Leuchtstoff aus einer Mehrzahl unterschiedlicher Leuchtstoffe gebildet ist, die bei Bestrahlung mit dem Laserlicht Konversionslicht in gewünschter Weise erzeugen, sodass das Konversionslicht weißes Licht darstellt. Darüber hinaus kann vorgesehen sein, dass auch ein Teil des empfangenen Laserlichts mit dem Konversionslicht vermischt wird, um das weiße Licht zu erzeugen. Darüber hinaus ist es natürlich möglich, Licht mit Farbnuancen, insbesondere auch farbiges Licht in gewünschter Weise zu erzeugen.

Die Konversionsvorrichtung weist den mindestens einen Leuchtstoff auf, der beispielsweise auf einem Träger der Konversionsvorrichtung angeordnet sein kann. Mit dem Leuchtstoff kann das vom Leuchtmittel zur Konversionsvorrichtung zugeführte Laserlicht in Konversionslicht gewandelt werden. Vorzugsweise enthält das Konversionslicht Licht mit einer Mehrzahl von unterschiedlichen Wellenlängen.

Das Sensorelement umfasst die Ultraschalleinheit mit einem Ultraschallgeber und -empfänger, die als Baueinheit zusammengefasst sein können. Vorzugsweise ist das Sensorelement an der Konversionsvorrichtung, insbesondere am Leuchtstoff, unmittelbar angebracht, sodass erzeugter Ultraschall möglichst ungehindert in die Konversionsvorrichtung beziehungsweise den Leuchtstoff eingekoppelt werden kann. Zugleich kann dadurch erreicht werden, dass reflektierte Ultraschallsignale mittels des Sensorelements erfasst werden können.

Vorzugsweise kann vorgesehen sein, dass Sensorsignale des Sensorelements zwecks einer weiteren Auswertung durch eine Auswerteeinheit dieser zugeführt werden können. Die Auswerteeinheit ermittelt aus den bereitgestellten Sensorsignalen des Sensorelements einen aktuellen Betriebszustand der Konversionseinrichtung beziehungsweise des Leuchtstoffes. Durch Vergleich mit wenigstens einem vorgegebenen Vergleichswert und/oder auch mit vorangegangenen Auswertungen kann die Auswerteeinheit ermitteln, ob die Konversionsvorrichtung beziehungsweise der Leuchtstoff in bestimmungsgemäßer Weise das empfangene Laserlicht in Konversionslicht wandelt. Stellt die Auswerteeinheit fest, dass dies nicht mehr der Fall ist, liefert sie ein Ausgangssignal beziehungsweise Zustandssignal, welches einem gestörten Zustand entspricht. Dieses Signal kann von einer übergeordneten Steuerung ausgewertet und dazu genutzt werden, das Leuchtmittel abzuschalten oder zumindest eine entsprechende Warnmeldung auszugeben.

Für die Realisierung des Sensorelements kann vorgesehen sein, dass die Ultraschalleinheit ein piezokeramisches Element aufweist. Das piezokeramische Element kann mit dem Leuchtstoff der Konversionsvorrichtung verbunden sein. Insbesondere kann das piezokeramische Element natürlich auch Träger für den Leuchtstoff sein. Dadurch kann eine gute akustische Kopplung des Sensorelements mit dem Leuchtstoff erreicht werden. Zugleich kann, insbesondere wenn das piezokeramische Element als Träger genutzt wird, eine vereinfachte Konstruktion erreicht werden, bei der die Konversionsvorrichtung das Sensorelement mit umfasst.

Gemäß einem Aspekt der Erfindung wird vorgeschlagen, dass das piezokeramische Element an einer Seite gegenüberliegend zu einer mit dem Laserlicht des Leuchtmittels beaufschlagten Seite des Leuchtstoffs angeordnet ist. Dadurch kann erreicht werden, dass der Leuchtstoff einerseits bezüglich des bestimmungsgemäßen Betriebs mit dem Laserlicht des Leuchtmittels beaufschlagt und andererseits von einer gegenüberliegenden Seite seine zuverlässige Funktion überwacht werden kann.

Gemäß einer Weiterbildung der Erfindung wird vorgeschlagen, dass die Konversionsvorrichtung zumindest teilweise reflektierend ausgebildet ist. Dadurch ist es möglich, dass das Konversionslicht in die Richtung von der Konversionsvorrichtung abgegeben wird, aus der der Konversionsvorrichtung das Laserlicht des Leuchtmittels zugeführt wird. Dadurch kann ein kompakter Aufbau erreicht werden. Beispielsweise kann zu diesem Zweck ergänzend vorgesehen sein, dass eine dem empfangenen Laserlicht des Leuchtmittels gegenüberliegende Seite des Leuchtstoffs an eine Metallisierung angrenzt, um das Konversionslicht und/oder das Laserlicht des Leuchtmittels reflektieren zu können.

Gemäß einer weiteren Ausgestaltung wird vorgeschlagen, dass die Konversionsvorrichtung zumindest teilweise transmittierend ausgebildet ist und einen Konversionsträger für den Leuchtstoff aufweist, wobei die Ultraschalleinheit, akustisch mit dem Konversionsträger gekoppelt ist. Bei dieser Ausgestaltung ist das Sensorelement, insbesondere die Ultraschalleinheit nicht unmittelbar mit dem Leuchtstoff akustisch verbunden, sondern stattdessen über den Konversionsträger der Konversionsvorrichtung. Der Konversionsträger trägt den Leuchtstoff. Der Konversionsträger kann beispielsweise eine Saphirscheibe oder dergleichen sein. Auf diese Weise kann auch eine für Transmission vorgesehene Konversionsvorrichtung mit der Überwachungseinrichtung gemäß der Erfindung überwacht werden. Dadurch können nichttransparente Sensorelemente eingesetzt werden.

Verfahrensseitig wird ferner vorgeschlagen, dass das Beaufschlagen mit Ultraschall zu einem vorgebbaren Zeitpunkt erfolgt. Bei dem vorgebbaren Zeitpunkt kann es sich auch um wiederkehrende Zeitpunkte handeln, insbesondere zu vorgegebenen Zeitabständen. Das Beaufschlagen mit Ultraschall kann mittels eines Ultraschallimpulses, beispielsweise in Form eines Burst-Signals, eines Einzelimpulses und/oder dergleichen erfolgen. Natürlich kann auch vorgesehen sein, dass ein einzelner sehr steiler Impuls erzeugt wird, der in den Leuchtstoff akustisch eingekoppelt wird und die entsprechenden Reflexionen mittels des Sensorelements erfasst werden. Darüber hinaus können natürlich auch Impulsfolgen, Schwingungen, insbesondere modulierte Schwingungen, Kombinationen hiervon oder dergleichen zum Beaufschlagen des Leuchstoffes mit Ultraschall genutzt werden. Gemäß einem weiteren Aspekt kann daher zum Zwecke des Beaufschlagens mit Ultraschall ein einzelner Impuls, eine Impulsfolge und/oder für ein vorgebbares Zeitintervall Ultraschall mit einer vorgebbaren Frequenz kontinuierlich erzeugt werden. Auf diese Weise ist es möglich, die Überwachungseinrichtung sowie das Verfahren der Erfindung an die konstruktiven und physikalischen Gegebenheiten anpassen zu können, beispielsweise an die Struktur des Leuchtstoffes, die Konstruktion der Konversionseinrichtung und/oder dergleichen.

Bei laserbasierten Weißlichtquellen als Beleuchtungseinrichtungen spielt die Bruchdetektion sowie Alterungserkennung fluoreszierender Konverter als Konversionsvorrichtungen eine wichtige Rolle. Im gewöhnlichen bestimmungsgemäßen Betrieb wird das von dem laserbasierten Leuchtmittel erzeugte monochromatische Laserlicht auf einen vorzugsweise floureszierenden Leuchtstoff der Konversionsvorrichtungen geführt. Dieser Leuchtstoff konvertiert das energiedichte Laserlicht vorzugsweise in Weißlicht. Bei einem solchen Leuchtstoff steht beispielsweise der Effekt der inneren Fluoreszenz dahinter. Eine solche Konversionsvorrichtung beschreibt eine Grenze zwischen dem sehr energiereichen Laserlicht und dem auf die Lichtverteilung projizierten Weißlicht.

Das durch das hier vom laserbasierten Leuchtmittel erzeugte Laserlicht kann eine Gefahr für die Umgebung darstellen. Deshalb ist der bestimmungsgemäße fehlerfreie Betrieb des Leuchtstoffs in der Regel wesentlich. Der Leuchtstoff ist üblicherweise aus gepressten Pulvern unterschiedlichster Materialien gebildet. Abhängig von Alterung und thermischer Beanspruchung kann der Leuchtstoff Schaden nehmen, insbesondere sein Aufbau. Deshalb ist die Detektion von Defekten des Leuchtstoffes wichtig. Eine Bruchdetektion als solche beim Leuchtstoff ist jedoch aufwendig. Bei aktuellen Beleuchtungseinrichtungen wird deshalb ein Blauanteil des abgegebenen Lichts sowie ein Gelbanteil des konvertierten Lichts der Beleuchtungseinrichtung überwacht. Dies nutzt die Erkenntnis, dass das Laserlicht zumeist im blauen beziehungsweise ultravioletten Wellenlängenbereich erzeugt und bereitgestellt wird, wobei der Leuchtstoff dieses Laserlichts in Licht anderer Wellenlängen, insbesondere größerer Wellenlängen konvertiert wird, sodass durch die Mischung der unterschiedlichen Wellenlängen des konvertierten Lichts und gegebenenfalls eines Teils des Laserlichts Weißlicht bereitgestellt wird. Wird im durch die Beleuchtungseinrichtung abgegebenen Licht der Anteil des gelben Lichts reduziert detektiert, so wird dies als Funktionsstörung beziehungsweise Beeinträchtigung des Leuchtstoffes detektiert.

Idealerweise würde das Spektrum des gesamten von der Beleuchtungseinrichtung abgegebenen Lichts analysiert. In der Praxis wird dies jedoch wegen des Aufwands und der Reduzierung der Lichtausbeute nicht realisiert. Stattdessen wird in der Praxis mittels einer Anzahl von Sensoren Streulicht detektiert, welches vom Leuchtstoff abgegeben wird. Auch wenn sich diese Maßnahme bewährt hat, besteht Verbesserungsbedarf.

Weitere Vorteile und Merkmale sind der folgenden Beschreibung eines Ausführungsbeispiels anhand von Figuren zu entnehmen. Das Ausführungsbeispiel dient lediglich der Erläuterung der Erfindung und ist für diese nicht beschränkend. In den Figuren verwendete Bezugszeichen bezeichnen gleiche Bauteile und Funktionen.

Es zeigen:
- Fig. 1: in schematischer Funktionsblockeinstellung ein Kraftfahrzeugscheinwerfer des Stands der Technik im bestimmungsgemäßen, ungestörten Betrieb;
- Fig. 2: der Kraftfahrzeugscheinwerfer gemäß Fig. 1 bei einem gestörten Betrieb aufgrund einer Beschädigung eines Leuchtstoffes;
- Fig. 3: der Kraftfahrzeugscheinwerfer gemäß Fig. 1 mit einem Ultraschallbasierten Sensorelement gemäß der Erfindung in einem bestimmungsgemäßen, ungestörten Betrieb;
- Fig. 4: der Kraftfahrzeugscheinwerfer gemäß Fig. 3 mit einer an das Sensorelement angeschlossenen Auswerteeinheit, die ein laserbasiertes Leuchtmittel erfindungsgemäß steuert in einem bestimmungsgemäßen, ungestörten Betrieb;
- Fig. 5: die Darstellung gemäß Fig. 4 im gestörten Betrieb; und
- Fig. 6: die Darstellung gemäß Fig. 5 nach der Reaktion der Auswerteeinheit auf ein entsprechendes Signal des Sensorelements gemäß der Erfindung.

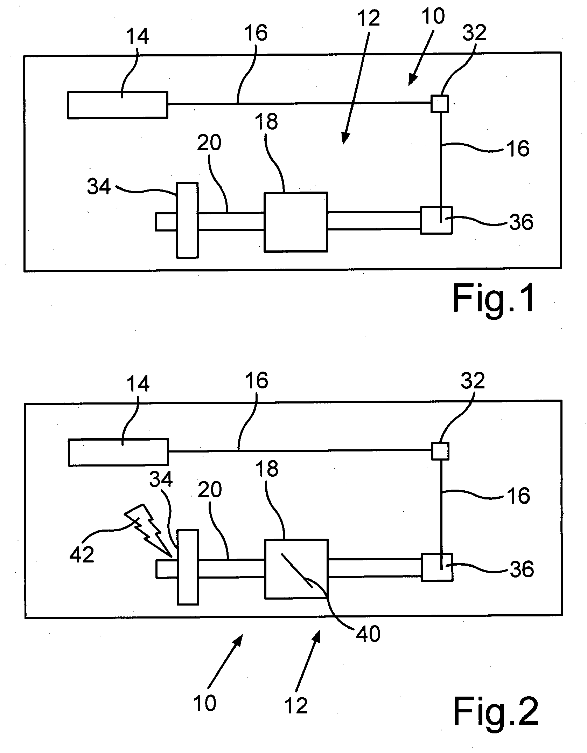

Fig. 1 zeigt in einer schematischen Prinzipblockschaltbildanordnung einen Kraftfahrzeugscheinwerfer 10 zum Bereitstellen von Licht für Beleuchtungszwecke in einem ungestörten bestimmungsgemäßen Betrieb der Lichterzeugung. Vorliegend wird mit dem Kraftfahrzeugscheinwerfer 10 weißes Licht erzeugt. Der Kraftfahrzeugscheinwerfer 10 ist Bestandteil eines nicht weiter dargestellten und bezeichneten Fahrzeugs, und dient bei diesem Fahrzeug als Scheinwerfer.

Der Kraftfahrzeugscheinwerfer 10 umfasst ein laserbasiertes Leuchtmittel 14, welches vorliegend durch eine Laserdiode gebildet ist, die Laserlicht 16 mit einer Wellenlänge von 450 nm erzeugt. Der Kraftfahrzeugscheinwerfer 10 umfasst ferner eine Konversionsvorrichtung 12, die ihrerseits einen nicht dargestellten Träger umfasst, auf dem ein Leuchtstoff 18 angeordnet ist. Vorliegend ist vorgesehen, dass der vom Träger gehaltene Leuchtstoff 18 im Transmissionsbetrieb betrieben wird, das heißt, dass auf einer Seite des Leuchtstoffes 18 das Laserlicht 16 der Laserdiode 14 auftrifft und gegenüberliegend weißes Licht vom Leuchtstoff 18 als Konversionslicht 20 ausgeht. Der Leuchtstoff 18 bewirkt diesbezüglich eine teilweise Konversion des Laserlichts 16, sodass das vom Leuchtstoff 18 ausgehende Konversionslicht 20 aufgrund seiner Farb- beziehungsweise Wellenlängenzusammenstellung ist.

Der Kraftfahrzeugscheinwerfer 10 umfasst ferner eine optische Baueinheit, die zwei Spiegel 32, 36 sowie eine Linse 34 umfasst. Diese dienen der Verarbeitung des Laserlichts 16 und des Konversionslichts 20, sodass der Kraftfahrzeugscheinwerfer 10 das Weißlicht für Beleuchtungszwecke bereitstellt. Das Laserlicht 16 gelangt von der Laserdiode 14 zu einem Mikrospiegel 32, der das Laserlicht 16 zu einem Aufweitungsspiegel 36 umlenkt. Dort wird das Laserlicht 16 hinsichtlich eines Strahldurchmessers aufgeweitet und zum Leuchtstoff 18 umgelenkt.

Eine Linse 34 dient der Bearbeitung des Konversionslichts 20 des Leuchtstoffes 18, sodass in gewünschter Weise die Beleuchtungswirkung des Kraftfahrzeugscheinwerfers 10 erreicht werden kann.

In Fig. 2 ist die Darstellung wie in Fig. 1 gezeigt, wobei jedoch im Unterschied zur Fig. 1 der Leuchtstoff 18 einen Riss 40 aufweist. Der Riss 40 kann beispielsweise während des bestimmungsgemäßen Fahrbetriebs des Fahrzeugs durch Erschütterungen, beispielsweise bei einem Unfall oder dergleichen, aufgetreten sein. Das Laserlicht 16, weiches vom Aufweitungsspiegel 36 dem Leuchtstoff 18 zugeführt wird, wird aufgrund des Risses 40 vom Leuchtstoff 18 nicht mehr vollständig in gewünschter Weise in Konversionslicht 20 gewandelt, sodass ein schädlicher Strahlungsanteil von Laserlicht 16 im Konversionslicht 20 auftritt. Dies ist durch einen Blitzpfeil 42 symbolisiert.

Die Spiegel 32 und 36 dienen der Lichtaufbereitung des Laserlichts 16 derart, dass eine Funktion des Leuchtstoffs 18 optimiert ist. Zu diesem Zweck ist der Spiegel 32 als Mikrospiegel ausgebildet, wohingegen der Spiegel 36 als Aufweitungsspiegel ausgebildet ist. Somit wird der Leuchtstoff 18 auf einer möglichst großen Fläche mit dem Laserlicht 16 beaufschlagt.

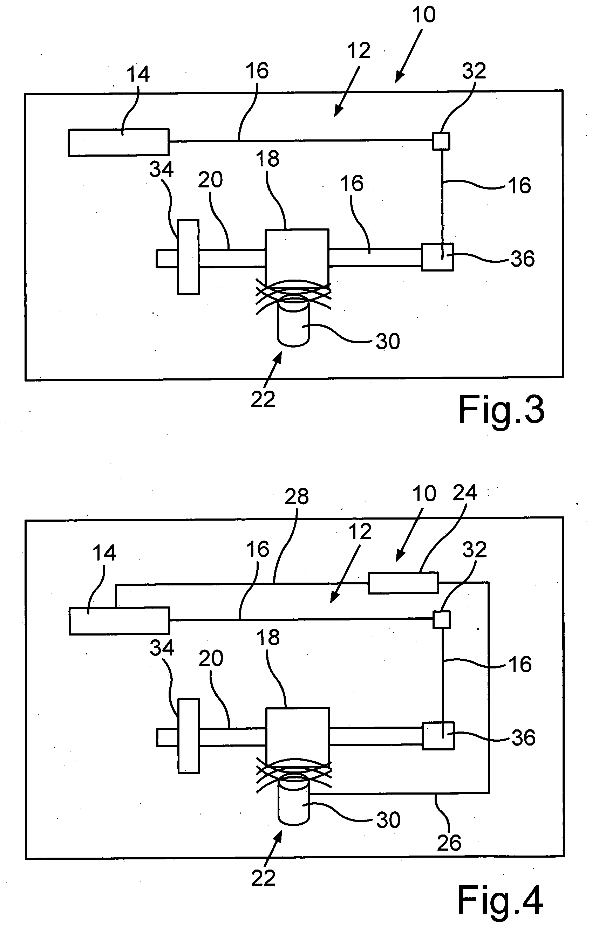

Fig. 3 zeigt eine Beleuchtungseinrichtung 10 gemäß der Erfindung, die im Wesentlichen die Komponenten des Kraftfahrzeugscheinwerfers 10 der Fig. 1 aufweist. Diesbezüglich wird deshalb auf die Ausführungen zur Fig. 1 verwiesen.

Im Unterschied zur Fig. 1 ist bei dem Kraftfahrzeugscheinwerfer 10 gemäß Fig. 3 erfindungsgemäß ein Sensorelement 22 vorgesehen, welches eine Ultraschalleinheit 30 mit einem Ultraschallgeber und -empfänger umfasst. Die Ultraschalleinheit 30 ist akustisch mit dem Leuchtstoff 20 gekoppelt. Vorliegend ist vorgesehen, dass ein Ultraschallburstimpuls in vorgebbaren Zeitabständen auf den Leuchtstoff 20 gegeben wird. Der Ultraschallburstimpuls ist derart auf den Leuchtstoff 20 abgestimmt, dass eine Resonanz ausgebildet werden kann. Mittels des Ultraschallempfängers der Ultraschalleinheit 30 wird ein reflektiertes Ultraschallsignal empfangen. Bereits kleinste Änderungen am Leuchtstoff 18 führen auf diese Weise zu Änderungen des empfangenen Ultraschallsignals am Ultraschallempfänger der Ultraschalleinheit 30.

Fig. 4 basiert auf dem Kraftfahrzeugscheinwerfer 10 gemäß Fig. 3, umfasst jedoch ergänzend eine Auswerteeinheit 24, die sowohl an die Ultraschalleinheit 30 als auch an die Laserdiode 14 angeschlossen ist. Die Ultraschalleinheit 30 liefert ein Sensorsignal 26 an die Auswerteeinheit 24. Diese wertet das Signal aus und erzeugt ein Zustandssignal 28, mittels welchem die Laserdiode 14 ein- beziehungsweise ausgeschaltet werden kann.

Die in Fig. 4 dargestellte Anordnung befindet sich in einem bestimmungsgemäßen, ungestörten Betriebszustand, das heißt, der Leuchtstoff 18 ist hinsichtlich seiner Integrität nicht beeinträchtigt. Die Auswerteeinheit 24 detektiert den bestimmungsgemäßen, ungestörten Betriebszustand und liefert ein entsprechendes Zustandssignal 28 an die Laserdiode 14, sodass der bestimmungsgemäße Betrieb des Kraftfahrzeugscheinwerfers 10 ausgeführt werden kann. Die Laserdiode 14 ist aktiv, das heißt, eingeschaltet.

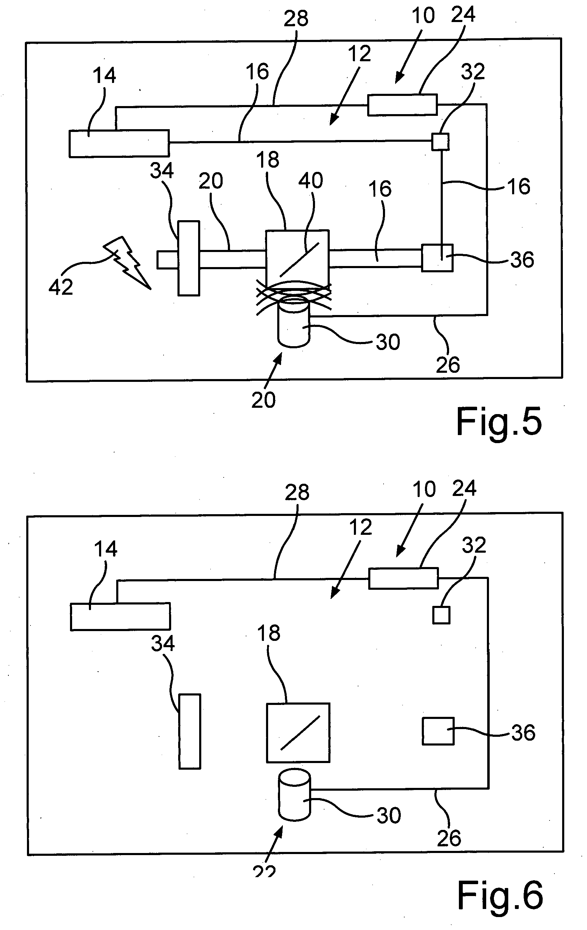

Fig. 5 zeigt eine Störung des Leuchtstoffs 18 mit einem Riss 40, wie er bereits zur Fig. 2 erläutert worden ist. Dies beeinträchtigt die Ultraschallreflektionen im Leuchtstoff 18, die mittels der Ultraschalleinheit 30 detektiert werden. Diese liefert ein entsprechendes Sensorsignal 26 an die Auswerteeinheit 24. Die Auswerteeinheit 24 detektiert eine Veränderung und erzeugt ein Zustandssignal 28 entsprechend des gestörten Zustands. Dieses Zustandssignal 28 wird an die Laserdiode 14 weitergegeben. Aufgrund dieses Zustandssignals wird die Laserdiode 14 abgeschaltet, sodass kein Laserlicht 16 weiter erzeugt wird. Dies ist in Fig. 6 dargestellt.

Das Ausführungsbeispiel dient lediglich der Erläuterung der Erfindung ist für diese nicht beschränkend. Natürlich können Funktionen insbesondere auch bezüglich der Auswertung oder der akustischen Kopplung beliebig gestaltet sein. Darüber hinaus ist die Erfindung natürlich nicht nur für die Anwendung bei Fahrzeugen beschränkt, sondern sie kann natürlich für beliebige Objekte, also auch für Gebäude, Landschaftsteile oder dergleichen, genutzt werden. Durch den Ultraschallsensor kann erreicht werden, dass der Leuchtstoff zuverlässig überwacht wird, wobei vorzugsweise lediglich ein einziger Sensor erforderlich ist.

Schließlich ist anzumerken, dass die für die erfindungsgemäße Einrichtung beschriebenen Vorteile und Merkmale sowie Ausführungsformen gleichermaßen für das entsprechende Verfahren gelten und umgekehrt. Folglich können für Vorrichtungsmerkmale entsprechende Verfahrensmerkmale und umgekehrt vorgesehen sein.

## Patentansprüche

1. Konversionsvorrichtung (12) für einen Kraftfahrzeugscheinwerfer (10) mit
- einem Leuchtstoff (18) zum Konvertieren von empfangenem Laserlicht (16) in Konversionslicht (20) und
- einem Sensorelement (22) zum Überwachen des Leuchtstoffs (18),
**dadurch gekennzeichnet, dass**
das Sensorelement (22) eine Ultraschalleinheit (30) mit einem Ultraschallgeber und -empfänger umfasst.

2. Konversionsvorrichtung (12) nach Anspruch 1, **dadurch gekennzeichnet, dass** die Ultraschalleinheit (30) ein piezokeramisches Element aufweist.

3. Konversionsvorrichtung (12) nach Anspruch 2, **dadurch gekennzeichnet, dass** das piezokeramische Element an einer Seite gegenüberliegend zu einer mit dem Laserlicht (16) beaufschlagten Seite des Leuchtstoffs (18) angeordnet ist.

4. Konversionsvorrichtung (12) nach einem der Ansprüche 1 bis 3, **dadurch gekennzeichnet, dass** die Konversionsvorrichtung (12) zumindest teilweise reflektierend ausgebildet ist.

5. Konversionsvorrichtung (12) nach einem der Ansprüche 1 bis 4, **dadurch gekennzeichnet, dass** die Konversionsvorrichtung (12) zumindest teilweise transmittierend ausgebildet ist und einen Konversionsträger für den Leuchtstoff (18) aufweist, wobei die Ultraschalleinheit (30) akustisch mit dem Konversionsträger gekoppelt ist.

6. Kraftfahrzeugscheinwerfer (10) zum Bereitstellen von Licht (20) für Beleuchtungszwecke, mit
- einer nach einem der vorhergehenden Ansprüche ausgebildeten Konversionsvorrichtung (12) und
- einem Leuchtmittel (14) zum Erzeugen des von der Konversionsvorrichtung (12) empfangenen Laserlichts (16).

7. Fahrzeug, **gekennzeichnet durch** einen Kraftfahrzeugscheinwerfer (10) nach Anspruch 6.

8. Verfahren zum Überwachen einer Konversionsvorrichtung (12) für einen Kraftfahrzeugscheinwerfer (10) mit folgenden Schritten:
- Empfangen von Laserlicht (16) eines Leuchtmittels (14) mit mindestens einer vorgebbaren Wellenlänge durch die Konversionsvorrichtung (12),
- Wandeln des empfangenen Laserlichts (16) des Leuchtmittels (14) in Konversionslicht (20) mittels mindestens eines Leuchtstoffes (18) der Konversionsvorrichtung (12) und
- Erfassen einer bestimmungsgemäßen Funktion der Konversionsvorrichtung (12) mittels eines Sensorelements (22),
**dadurch gekennzeichnet,**
**dass** das Erfassen mittels Ultraschall erfolgt, zu welchem Zweck der Leuchtstoff (18) mittels des Sensorelements (22) mit Ultraschall beaufschlagt wird.

9. Verfahren nach Anspruch 8, **dadurch gekennzeichnet, dass** das Beaufschlagen mit Ultraschall zu einem vorgebbaren Zeitpunkt erfolgt.

10. Verfahren nach Anspruch 8 oder 9, **dadurch gekennzeichnet, dass** zum Zwecke des Beaufschlagens mit Ultraschall ein einzelner Impuls, eine Impulsfolge und/oder für ein vorgebbares Zeitintervall Ultraschall mit einer vorgebbaren Frequenz kontinuierlich erzeugt wird.

## Claims

1. A conversion device (12) for a motor vehicle headlight (10), with
- a luminescent material (18) for converting received laser light (16) into conversion light (20), and
- a sensor element (22) for monitoring the luminescent material (18),
**characterised in that**
the sensor element (22) comprises an ultrasonic unit (30) comprising an ultrasonic transducer and receiver.

2. The conversion device (12) according to claim 1, **characterised in that** the ultrasonic unit (30) has a piezoceramic element.

3. The conversion device (12) according to claim 2, **characterised in that** the piezoceramic element is disposed on a side that is opposite to a side of the luminescent material (18) that is exposed to the laser light (16).

4. The conversion device (12) according to any of claims 1 to 3, **characterised in that** the conversion device (12) is designed to be at least partially reflective.

5. The conversion device (12) according any of claims 1 to 4, **characterised in that** the conversion device (12) is designed to be at least partially transmissive and has a conversion carrier for the luminescent material (18), with the ultrasonic unit (30) being acoustically coupled with the conversion carrier.

6. A motor vehicle headlight (10) for providing light (20) for illumination purposes, with
- a conversion device (12) designed according to any of the preceding claims, and
- illumination means (14) for generating the laser light (16) received from the conversion device (12).

7. A vehicle **characterised by** a motor vehicle headlight (10) according to claim 6.

8. A method for monitoring a conversion device (12) for a motor vehicle headlight (10), with the following steps:
- receiving laser light (16) of an illumination means (14) with at least one predeterminable wavelength by the conversion device (12),
- converting the received laser light (16) of the illumination means (14) into conversion light (20) by means of at least one luminescent material (18) of the conversion device (12), and
- detecting an intended function of the conversion device (12) by means of a sensor element (22),
**characterised in that**
the detecting is carried out using ultrasound, for which purpose ultrasound is applied to said luminescent material (18) by means of said sensor element (22).

9. The method as claimed in claim 8, **characterised in that** the ultrasound application is carried out at a predeterminable point in time.

10. The method as claimed in claim 8 or 9, **characterised in that** for the purpose of applying ultrasound, ultrasound having a predeterminable frequency is continuously generated as a single pulse, a pulse sequence and/or for a predeterminable time interval.

## Revendications

1. Dispositif de conversion (12) pour phare de véhicule automobile (10) avec
- un luminophore (18) destiné à convertir de la lumière laser (16) reçue en lumière de conversion (20) et
- un élément formant capteur (22) destiné à surveiller le luminophore (18),
**caractérisé en ce que**
l'élément formant capteur (22) comprend une unité ultrasonique (30) avec un émetteur et récepteur d'ultrasons.

2. Dispositif de conversion (12) selon la revendication 1, **caractérisé en ce que** l'unité à ultrasons (30) présente un élément piézocéramique.

3. Dispositif de conversion (12) selon la revendication 2, **caractérisé en ce que** l'élément piézocéramique est agencé au niveau d'un côté opposé à un côté, exposé à la lumière laser (16), du luminophore (18).

4. Dispositif de conversion (12) selon l'une quelconque des revendications 1 à 3, **caractérisé en ce que** le dispositif de conversion (12) est réalisé de manière à être au moins partiellement réfléchissant.

5. Dispositif de conversion (12) selon l'une quelconque des revendications 1 à 4, **caractérisé en ce que** le dispositif de conversion (12) est réalisé de manière à être au moins partiellement transmissif et présente un support de conversion pour le luminophore (18), dans lequel l'unité ultrasonique (30) est couplée de manière acoustique au support de conversion.

6. Phare de véhicule automobile (10) destiné à fournir de la lumière (20) à des fins d'éclairage, avec
- un dispositif de conversion (12) réalisé selon l'une quelconque des revendications précédentes et
- une source lumineuse (14) destinée à générer la lumière laser (16) reçue du dispositif de conversion (12).

7. Véhicule **caractérisé par** un phare de véhicule automobile (10) selon la revendication 6.

8. Procédé de surveillance d'un dispositif de conversion (12) pour un phare de véhicule automobile (10), avec les étapes ci-dessous :
- réception, par le dispositif de conversion (12), de lumière laser (16) d'une source lumineuse (14) avec au moins une longueur d'onde pouvant être prédéfinie,
- transformation de la lumière laser (16) reçue de la source lumineuse (14) en lumière de conversion (20) au moyen d'au moins un luminophore (18) du dispositif de conversion (12) et
- détection d'un fonctionnement nominal du dispositif de conversion (12) au moyen d'un élément formant capteur (22),
**caractérisé en ce que**
la détection intervient au moyen d'ultrasons, raison pour laquelle le luminophore (18) est exposé à des ultrasons au moyen de l'élément formant capteur (22).

9. Procédé selon la revendication 8, **caractérisé en ce que** l'exposition à des ultrasons intervient à un instant pouvant être prédéfini.

10. Procédé selon la revendication 8 ou 9, **caractérisé en ce qu'**une impulsion unique, un train d'impulsions et/ou des ultrasons pendant un intervalle de temps pouvant être prédéfini avec une fréquence pouvant être prédéfinie est/sont généré(s) en continu aux fins de l'exposition à des ultrasons.
